# EUROPEAN PATENT APPLICATION

(11) **EP 4 852 706 A1**
(43) Date of publication of application: **09.12.2026**
(21) Application number: 25224281.3
(22) Date of filing: 17.12.2025
(51) Int. Cl.: H10W 90/20, H10W 90/00, H10W 70/60, H10W 90/26

(54) **SEMICONDUCTOR PACKAGES INCLUDING DIE STACKS WITH CAPACITORS AND RELATED METHODS**

(30) Priority: 05.06.2025 US 202519229540
(71) Applicant: INTEL Corporation, Santa Clara, CA 95054 (US)
(72) Inventor: MALLIK, Debendra, Chandler, 85226 (US); KHARE, Surhud Vikas, Buffalo, 14209 (US); SHARAN, Sujit, Chandler, 85286 (US); RADHAKRISHNAN, Kaladhar, Chandler, 85226 (US); MIN, Yongki, Phoenix, 85045 (US); VENKATARAMAN, Srikrishnan, 560103 Bangalore (IN); MAJHI, Prashant, Santa Clara, 95054 (US); PELTO, Christopher M., Beaverton, 97006 (US)
(74) Representative: 2SPL Patentanwälte PartG mbB

(57) **Abstract**

Semiconductor packages including die stacks with capacitors and related methods are disclosed herein. An example apparatus disclosed herein includes a package substrate, a first chip including a first surface adjacent to the package substrate, a second surface distal to the package substrate, a capacitor adjacent to the second surface, and circuitry on the first surface, and a second chip in a stack with the first chip, the second chip on the second surface, the second chip electrically coupled to the capacitor.

## Description

### BACKGROUND

In many electronic devices, integrated circuit (IC) chips and/or semiconductor dies are connected to larger circuit boards such as motherboards and/or other types of printed circuit boards (PCBs) via a package substrate. IC chips can be coupled to a variety of components via traces extending through printed circuit boards.

### BRIEF DESCRIPTION OF THE DRAWINGS

FIG. 1 is a cross-sectional side view of an example implementation of an integrated circuit (IC) package constructed in accordance with teachings of this disclosure.
FIG. 2A is a cross-sectional side view of a first example die stack including a redistribution layer metal insulator metal capacitor that can be used with the integrated circuit package of FIG. 1.
FIG. 2B is a cross-sectional side view of a second example die stack including the redistribution layer metal insulator metal capacitor of FIG. 2A that can be used with the integrated circuit package of FIG. 1.
FIG. 3A is a cross-sectional side view of a third example die stack including a deep trench capacitor that can be used with the integrated circuit package of FIG. 1.
FIG. 3B is a cross-sectional side view of a fourth example die stack including the deep trench capacitor of FIG. 3A that can be used with the integrated circuit package of FIG. 1.
FIG. 4A is a cross-sectional side view of a fifth example die stack including the redistribution layer metal insulator metal capacitor of FIGS. 2A and 2B and the deep trench capacitor of FIGS. 3A or 3B that can be used with the integrated circuit package of FIG. 1.
FIG. 4B is a cross-sectional side view of a sixth example die stack including the redistribution layer metal insulator metal capacitor of FIGS. 2A and 2B and the deep trench capacitor of FIGS. 3A or 3B that can be used with the integrated circuit package of FIG. 1.
FIG. 5 is a cross-sectional side view of a seventh example die stack including a solder bump connection that can be used with the integrated circuit package of FIG. 1.
FIGS. 6, 7, 8, 9, 10, 11, 12, 13, and 14 are cross-sectional views depicting the fifth die stack of FIG. 4A in various stages of an example manufacturing process.
FIG. 15 is a flowchart representative of an example manufacturing process for manufacturing the hybrid core of FIG. 4A.
FIG. 16 is a top view of a wafer and dies that may be included in an IC package constructed in accordance with teachings disclosed herein.
FIG. 17 is a cross-sectional side view of an IC device that may be included in an IC package constructed in accordance with teachings disclosed herein.
FIG. 18 is a cross-sectional side view of an IC device assembly that may include an IC package constructed in accordance with teachings disclosed herein.
FIG. 19 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

### DETAILED DESCRIPTION

In recent years, three-dimensional integrated circuits (3DIC) have become increasingly common in electronic devices. 3DICs include two or more vertically stacked integrated circuits, such as dies, that are electrically coupled via one or more vias. As used herein, a "front surface" of a die is the surface of the die on which circuitry is supported and a "back surface" of a die is the surface of a die opposite the front surface. As used herein, 3DICs including a plurality of stacked dies are referred to as "die stacks." Typically, the top die of a 3DIC is closer to the cooling features of the package including the die stack (e.g., a heat spreader of the package, etc.). As such, the top die of a die stack can be more easily cooled. Because the top dies of 3DICs can be more easily cooled, such dies typically have a greater processing capacity and power demand than the bottom die(s) of a 3DIC.

One type of 3DIC is face-to-back (F2B) stacked dies, in which a front surface of a top die is vertically mounted on a back surface of a bottom die. In F2B 3DIC die stacks, communication between (1) the top dies and (2) the bottom dies and/or other features associated with the package must be transmitted through the vias extending through the bottom die. The impedance associated with the communication through the vias extending through the bottom die limits the power delivery provided by capacitors in the front surface of the bottom die and/or within the substrate of the package. To mitigate such power delivery limits, some prior F2B 3DICs have high vias density in the bottom dies to reduce power delivery impedance to the top die. However, such prior 3DICs highly penalize the available circuitry area of the bottom die due to the high density of vias.

Examples disclosed herein overcome some or all of the above-noted deficiencies and include F2B 3DICs that include capacitors adjacent to the back surface of a bottom die. Some example die stacks disclosed herein include metal-insulator-metal (MIM) capacitors disposed between redistribution layers patterned on the back side of a bottom die. Some die stacks disclosed include a top die mounted to a bottom die via a hybrid bonding interconnect (HBI). Some die stacks disclosed herein include bottom dies with deep trench capacitors that are flush with the back surface of the bottom dies. The dies stacks disclosed herein provide increased power delivery to the top die due to the reduced impedance between the capacitors providing power delivery to the top dies of the die stack. The F2B die stacks disclosed herein provide enhanced power delivery to the top dies when compared to prior die stacks.

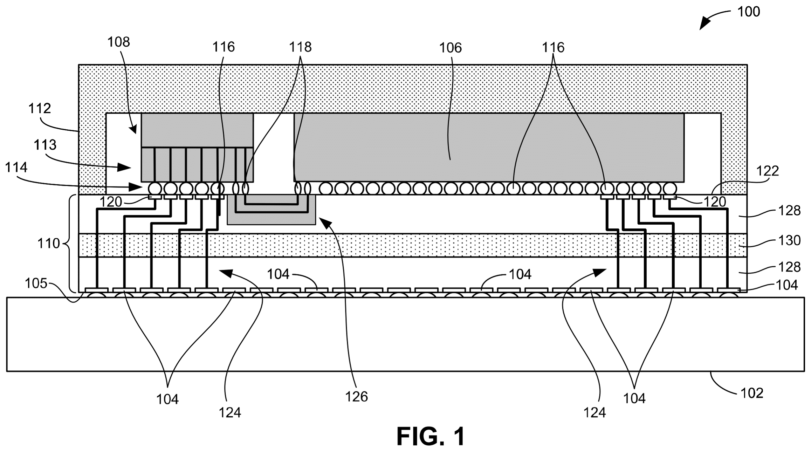

FIG. 1 illustrates an example integrated circuit (IC) package 100 constructed in accordance with teachings disclosed herein. In the illustrated example, the IC package 100 is electrically coupled to a circuit board 102 via an array of contact pads 104 (e.g., lands, etc.) on a mounting surface 105 (e.g., a bottom surface) of the package. In some examples, the IC package 100 may include balls, pins, and/or pads, in addition to or instead of the contact pads 104, to enable the electrical coupling of the IC package 100 to the circuit board 102. In this example, the IC package 100 includes a die 106 (e.g., a silicon die, a semiconductor die, etc.) and an example die stack 108 that is mounted to a package substrate 110 and enclosed by a package lid 112 (e.g., a mold compound, a heat spreader, etc.). Thus, the package substrate 110 is an example means for supporting a semiconductor die. While the example IC package 100 of FIG. 1 includes the die 106 and the die stack 108, in other examples, the IC package 100 may include additional dies. In some examples, some or all of the die 106, the die stack 108, or a separate die are embedded in the package substrate 110. The die 106 can provide any suitable type of functionality (e.g., data processing, memory storage, etc.). In some examples, the die 106 can be implemented by a 3DIC (e.g., two or more vertically arranged dies, etc.) that is similar to the die stack 108.

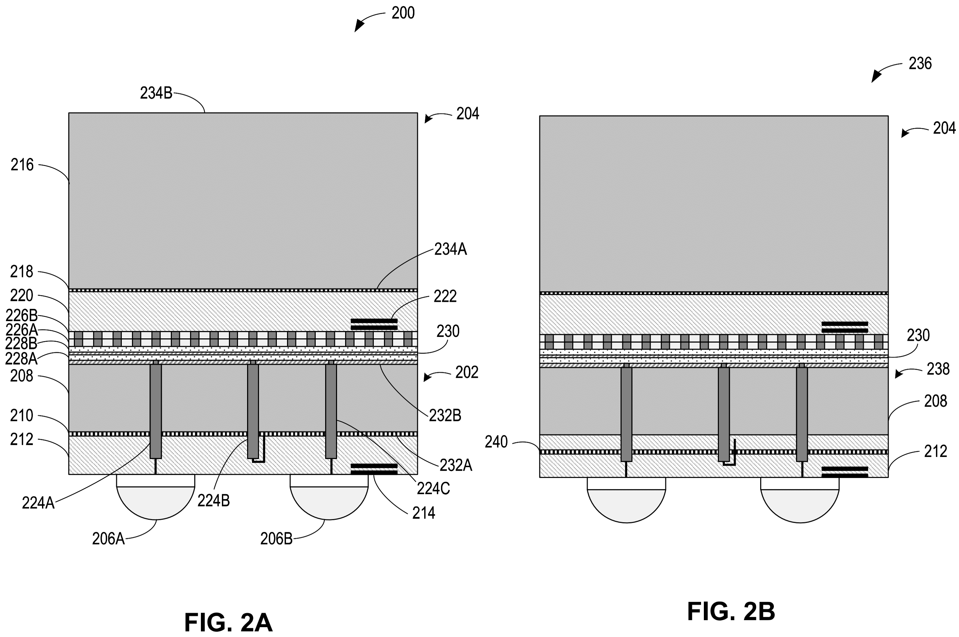

The die stack 108 of this example is a 3DIC. That is, in the illustrated example of FIG. 1, the die stack 108 includes two vertically arranged dies. In other examples, the die stack 108 can include a different number of stacked dies (e.g., three dies, four dies, sixteen dies, etc.). The die stack 108 can provide any suitable type of functionality (e.g., data processing, memory storage, etc.). In the illustrated example of FIG. 1, the vertically adjacent one(s) of the dies of the die stack 108 are connected by vias 113, which enables electrical communication between adjacent dies of the die stack 108. Example die stacks implemented in accordance with teachings of this disclosure are described below in conjunction with FIGS. 2A-5.

In the illustrated example of FIG. 1, the die 106 and the die stack 108 are electrically and mechanically coupled to the package substrate 110 via corresponding arrays of interconnects 114. In the illustrated example of FIG. 1, the interconnects 114 are bumps. In other examples, the interconnects 114 can be implemented any other type of electrical connection in addition to or instead of the bumps shown (e.g., balls, pins, pads, wire bonding, etc.). The electrical connections between the die 106 and the die stack 108 and the package substrate 110 (e.g., the interconnects 114, etc.) are referred to herein as "first level interconnects." The electrical connections between the IC package 100 and the circuit board 102 (e.g., the contact pads 104, etc.) are referred to herein as "second level interconnects." In some examples, one or both the die 106 and the die stack 108 are stacked on top of one or more other dies and/or an interposer. In some such examples, the die 106 and the die stack 108 are coupled to the underlying die and/or interposer through a first set of first level interconnects and the underlying die and/or interposer may be connected to the package substrate 110 via a separate set of first level interconnects associated with the underlying die and/or interposer. Thus, as used herein, first level interconnects refer to interconnects (e.g., balls, bumps, pins, pads, wire bonding, etc.) between a die and a package substrate or a die and an underlying die and/or interposer.

In the illustrated example of FIG. 1, the interconnects 114 of the first level interconnects include two different types of bumps corresponding to core bumps 116 and bridge bumps 118. As used herein, the core bumps 116 are bumps on the die 106 and the die stack 108 through which electrical signals pass between the die 106 and the die stack 108 and components external to the IC package 100. That is, as shown in the illustrated example of FIG. 1, when the die 106 and the die stack 108 are mounted to the package substrate 110, the core bumps 116 are physically connected and electrically coupled to contact pads 120 on an inner surface 122 of the package substrate 110. The contact pads 120 on the inner surface 122 of the package substrate 110 are electrically coupled to the contact pads 104 on the mounting surface 105 of the package substrate 110 (e.g., a surface opposite the inner surface 122, an external bottom surface, etc.) via internal interconnects 124 within the package substrate 110. As a result, there is a continuous electrical signal path between the interconnects 114 and the contacts pads 104 mounted to the circuit board 102 that pass through the contact pads 120 and the internal interconnects 124 provided therebetween.

As used herein, the bridge bumps 118 are bumps on the die 106 and the die stack 108 through which electrical signals pass between different ones of the die 106 and the die stack 108 within the IC package 100. Thus, as shown in the illustrated example of FIG. 1, the bridge bumps 118 of the die 106 are electrically coupled to the bridge bumps 118 of the die stack 108 via an interconnect bridge 126 embedded in the package substrate 110. As represented in FIG. 1, core bumps 116 are typically larger than bridge bumps 118. In some examples, the interconnect bridge 126 and the associated bridge bumps 118 are omitted. In some examples, the IC package 100 includes a capacitor (e.g., a deep trench capacitor, etc.) embedded in the package substrate 110. In some such examples, the capacitor is coupled to the die stack 108.

For purposes of illustration, the internal interconnects 124 are shown as straight lines extending directly between the contact pads 104 on the mounting surface 105 and the contact pads on the inner surface 122. However, in some examples, the internal interconnects 124 are defined by traces or routing in separate conductive (e.g., metal) layers within build-up regions 128 on one or both sides of a substrate core 130 in the package substrate 110. In such examples, the build-up regions 128 include dielectric layers to separate the different conductive layers. In such examples, the traces or routing in the different conductive layers are electrically coupled (to define the complete electrical path of the internal interconnects 124) by conductive (e.g., metal) vias extending between the different conductive layers. Further, in some examples, the internal interconnects 124 include vias that extend through the substrate core 130. In some examples, the substrate core 130 includes (e.g., is composed of, etc.) an organic material. Additionally or alternatively, the substrate core 130 can include (e.g., is composed of, etc.) glass.

FIG. 2A is a cross-sectional side view of a first example die stack 200 implemented in accordance with the teachings of this disclosure. In some examples, the first die stack 200 can implement the die stack 108 of FIG. 1. In the illustrated example of FIG. 2A, the die stack 200 includes an example first bottom die 202, an example first top die 204, an example first interconnect bump 206A, and an example second interconnect bump 206B. In the illustrated example of FIG. 2A, the first bottom die 202 includes an example first base 208, an example first transistor layer 210, example first circuitry 212, and an example first capacitor 214. In the illustrated example of FIG. 2A, the first top die 204 includes an example second base 216, an example second transistor layer 218, example second circuitry 220, and an example second capacitor 222.

In the illustrated example of FIG. 2A, the first die stack 200 includes an example first via 224A, an example second via 224B, an example third via 224C, an example first interconnect layer 226A, an example second interconnect layer 226B, an example first redistribution layer 228A, an example second redistribution layer 228B, and an example redistribution layer metal insulator metal (RDL MIM) capacitor 230. In the illustrated example of FIG. 2A, the first base 208 includes an example first front surface 232A and an example first back surface 232B. In the illustrated example of FIG. 2A, the second base 216 includes an example second front surface 234A and an example second back surface 234B.

The dies 202, 204 are semiconductor dies (e.g., silicon dies, etc.) that are configured to be mounted on a package substrate (e.g., the package substrate 110 of FIG. 1, etc.). The dies 202, 204 are similar to the dies of the die stack 108 of FIG. 1, except as noted otherwise. Like the dies of the die stack 108 of FIG. 1, one or more of the dies 202, 204 can provide any suitable type of functionality (e.g., data processing, memory storage, etc.). In some examples, the dies 202, 204 have a same functionality. In other examples, the dies 202, 204 have functionalities, which are different from the functionalitie(s) of one or more other dies. In some examples, the first top die 204 demands more power than the first bottom die 202 (e.g., the first top die 204 has a greater processing capacity than the first bottom die 202, etc.). In some examples, the distance of the first top die 204 from the substrate package and/or adjacency of the first top die 204 to the cooling features of the package (e.g., the package lid 112 of FIG. 1, a heat sink coupled to the IC package, etc.) facilitates the cooling of the first top die 204 when compared to the first bottom die 202. In some examples, the second back surface 234B of the first top die 204 abuts a package lid of a semiconductor package (e.g., the package lid 112 of FIG. 1, etc.).

The bases 208, 216 are the base layers of the dies 202, 204, respectively. The bases 208, 216 support the other components of the dies 202, 204 (e.g., the transistor layers 210, 218, the circuitry 212, 220, the capacitors 214, 222, etc.). In some examples, the bases 208, 216 include (e.g., are composed of, etc.) silicon (e.g., crystalline silicon, etc.). Additionally or alternatively, the bases 208, 216 include (e.g., are composed of, etc.) any other suitable semiconductor material (e.g., germanium, gallium arsenide, silicon carbide, etc.). In some examples, the bases 208, 216 are the remaining portions of a singulated wafer associated with the fabrication of the dies 202, 204. The bases 208, 216 are also referred to herein as the "bulk silicon" and "the substrate" of the dies 202, 204, respectively.

In the illustrated example of FIG. 2A, the first die stack 200 is a three-dimensional integrated circuit (3DIC). That is, the first bottom die 202 and the first top die 204 are vertically arranged (e.g., the dies 202, 204 are vertically stacked, etc.). In the illustrated example of FIG. 2A, the first bottom die 202 and the first top die 204 are arranged in a face-to-back (F2B) configuration. That is, in the illustrated example of FIG. 2A, the second front surface 234A of the first top die 204 is adjacent to the first back surface 232B of the first bottom die 202 (e.g., the second front surface 234A of the first top die 204 is facing the first back surface 232B of the first bottom die 202, etc.). In other examples, the first bottom die 202 and the first top die 204 can be arranged in other configurations (e.g., a face-to-face (F2F) configuration, etc.). In some such examples, the first front surface 232A of the first bottom die 202 is adjacent to the second front surface 234A of the first top die 204.

The transistor layers 210, 218 are layers of components that are directly adjacent to (e.g., abutting, etc.) the bases 208, 216 of the dies 202, 204, respectively. In some examples, the transistor layers 210, 218 are patterned directly into the bases 208, 216 via front end of line (FEOL) fabrication methods. In the illustrated example of FIG. 2A, the transistor layers 210, 218 are disposed on the front surfaces 232A, 234A of the bases 208, 216, respectively. In other examples, one or both of the transistor layers 210, 218 can be spaced from the bases 208, 216. Example dies stacks including transistor layers spaced from the bases 208, 216 are described below in conjunction with FIG. 2B. In some examples, the transistor layers 210, 218 are the components and/or structures that distribute power to the circuitry 212, 220 of dies 202, 204, respectively. Additionally or alternatively, one of both of the transistor layers 210, 218 provide one or more other functionalities. In some examples, the transistor layers 210, 218 can include components in addition to transistors (e.g., capacitors, resistors, etc.).

The circuitry 212, 220 are the electrical components that provide functionality to the dies 202, 204. For example, the circuitry 212, 220 can include one or more processing structures, one or more memory storage structures, etc. In some examples, the circuitry 212, 220 can include a plurality of vertically arranged layers of metal and insulators. In the illustrated example of FIG. 2A, the circuitry 212, 220 are disposed on the front surfaces 232A, 234A of the dies 202, 204, respectively.

In the illustrated example of FIG. 2A, the circuitry 212, 220 includes the capacitors 214, 222, respectively. The capacitors 214, 222 are metal-insulator-metal (MIM) capacitors. The capacitors 214, 222 provide power delivery to the first bottom die 202 and the first top die, respectively. In some examples, the first capacitors 214 also facilitate power delivery to the first top die 204. In some such examples, the bandwidth and impedance associated with the vias 224A, 224B, 224C limits the power delivery provided by the first capacitor 214 to the second circuitry 220 of the first top die 204. In the illustrated example of FIG. 2A, the dies 202, 204 each include a single MIM capacitor in the circuitry 212, 220 (e.g., the capacitors 214, 222, etc.). One or both of the dies 202, 204 can include additional capacitors (e.g., capacitors disposed within the circuitry 212, 220, respectively, etc.). In some examples, one or both of the capacitors 214, 222 are absent.

The vias 224A, 224B, 224C can implement the vias 113 of FIG. 1. The vias 224A, 224B, 224C are interconnects that extend through the base 208 of the first bottom die 202. In some examples, the vias 224A, 224B, 224C are through silicon vias (TSVs). The vias 224A, 224B, 224C enable power and/or electrical signals to be transmitted to the first top die 204. In the illustrated example of FIG. 2, the first via 224A and the third via 224C connect the first top die 204 (e.g., the second circuitry 220, etc.) to the first interconnect bump 206A and the second interconnect bump 206B, respectively. In the illustrated example of FIG. 2A, the second via 224B connects the first top die 204 to the first circuitry 212 of the first bottom die 202. While the die stack 200 of FIG. 2A is depicted with three vias (e.g., the vias 224A, 224B, 224C, etc.), in other examples, the first bottom die 202 can include a different quantity of vias (e.g., one via, five vias, one hundred vias, etc.).

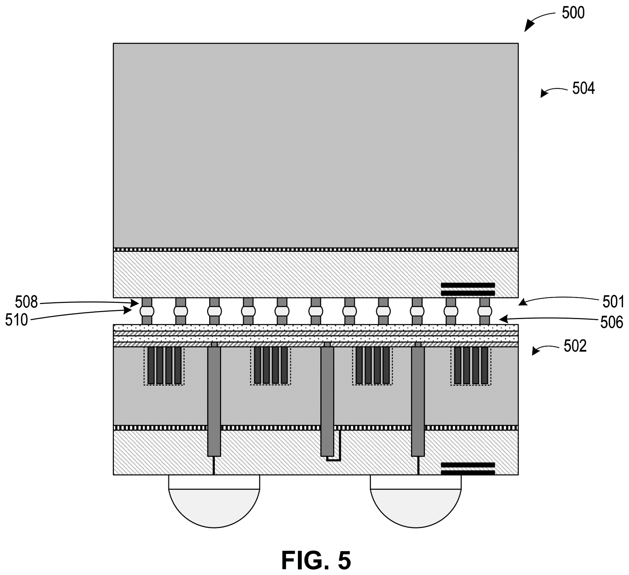

The interconnect layers 226A, 226B connect the first bottom die 202 to the first top die 204. In the illustrated example of FIG. 2A, the first interconnect layer 226A is formed on the first back surface 232B of the first bottom die 202 and the second interconnect layer 226B is formed on the second front surface 234A of the first top die 204. In the illustrated example of FIG. 2A, the interconnect layers 226A, 226B form a hybrid bond interconnect (HBI) between the first bottom die 202 and the first top die 204. That is, the first interconnect layer 226A includes laterally alternating portions of a dielectric material (e.g., silicon oxide, etc.) and metal (e.g., copper, etc.) that are aligned to corresponding dielectric and metal portions of the second interconnect layer 226B. In other examples, the dies 202, 204 can be bonded via a different bonding technology (e.g., a different type of fusion bonding, solder ball interconnect, via one or more pins, via one or more lands, etc.). An example die stack implemented in accordance with teachings of this disclosure including dies bonded via a solder ball interconnect is described below in conjunction with FIG. 5.

The redistribution layers 228A, 228B include a dielectric filler material (e.g., Ajinomoto build-up film (ABF), etc.) and one or more conductive interconnections (e.g., vias, pads, etc.) therein. The conductive interconnections of the redistribution layers 228A, 228B transmit power and/or electrical signals between adjacent ones of the dies 202, 204. In some examples, the redistribution layers 228A, 228B facilitate components between non-vertically aligned components of the dies 202, 204 (e.g., the redistribution layers 228A, 228B laterally and/or horizontally redistribute power and/or electrical signals flowing therethrough, etc.). In the illustrated example of FIG. 2A, the redistribution layers 228A, 228B are adjacent to the first back surface 232B of the first bottom die 202. In the illustrated example of FIG. 2A, the first redistribution layer 228A is between the RDL MIM capacitor layer 230 and the interconnect layers 226A, 226B. In the illustrated example of FIG. 2A, the second redistribution layer 228B is between the RDL MIM capacitor layer 230 and the first base 208. In some examples, one or both of the redistribution layers 228A, 228B are absent.

In the illustrated example of FIG. 2, the first top die 204 receives electrical communications and/or power via the connection between the first bottom die 202 and the first top die 204. That is, electrical communication between the second circuitry 220 and the package to which the first die stack 200 is mounted sequentially passes through (1) the interconnect layers 226A, 226B, (2) the first redistribution layer 228A, (3) the RDL MIM capacitor layer 230, (3) the second redistribution layer 228B, (4) the vias 224A, 224B, and (5) the interconnect bumps 206A, 206B. The comparatively long distance between the first top die 204 and the interconnect bumps 206A, 206B causes a comparatively large amount of impedance for power and/or electrical signals transmitted there between. This impedance reduces the effectiveness of capacitance of the capacitors within the package (e.g., a deep trench capacitor in the package, etc.). Similarly, the impedance associated with the distance to the first top die 204 limits the effectiveness of capacitors formed on the first front surface 232A (e.g., the first capacitor 214, etc.).

The RDL MIM capacitor layer 230 provides power delivery, filtering, power storage, filtering, and/or other functionality associated with capacitors to the first top die 204. The RDL MIM capacitor layer 230 includes one or more metal-insulator-metal capacitors. Additionally or alternatively, the RDL MIM capacitor layer 230 can include one or more metal-oxide-metal capacitors. In some examples, the electrodes of the RDL MIM capacitor layer 230 (e.g., the metal of the RDL MIM capacitor layer 230, etc.) can include (e.g., be composed of, etc.) any suitable electrically conductive material(s), including copper, aluminum, nickel, gold, silver, titanium, tantalum, ruthenium, and a combination of one or more thereof. In some examples, the non-conductive portions of the RDL MIM capacitor layer 230 can include (e.g., be composed of, etc.) a plastic film, an oxide (e.g., hafnium oxide, silicon oxide, tantalum oxides, aluminum oxides, etc.), and/or another material (e.g., a high-k dielectric, silicon nitride, barium strontium titanate, barium titanate, lead zirconium titanate, tantalum titanate, lead lanthanum titanate, strontium titanate, barium strontium niobate, barium zirconium titanate or barium titanium niobate, etc.).

In the illustrated example of FIG. 2A, the RDL MIM capacitor layer 230 is between the first redistribution layer 228A and the second redistribution layer 228B. In other examples, the RDL MIM capacitor layer 230 can have any other suitable location (e.g., vertically below the first redistribution layer 228A, vertically above the second redistribution layer 228B, etc.). In the illustrated example of FIG. 2A, the RDL MIM capacitor layer 230 is supported on the first back surface 232B of the first bottom die 202. In some examples, the positioning of the RDL MIM capacitor layer 230 provides the first top die 204 with capacitance functionality (e.g., storage, power supply, etc.) without requiring routing through the vias 224A, 224B, 224C. That is, interaction with the RDL MIM capacitor layer 230 offers comparatively lower impedance losses for the first top die 204 than will be experienced by interaction with capacitors on the first front surface 232A of the first bottom die 202. Accordingly, the RDL MIM capacitor layer 230 enables the first top die 204 in F2B die stacks to have greater power demands than prior die stacks without comparatively high impedance losses.

FIG. 2B is a cross-sectional side view of a second example die stack 236 including the first top die 204 and the RDL MIM capacitor layer 230 of FIG. 2A. The second die stack 236 is similar to the first die stack 200 of FIG. 2A, except that the first top die 204 is mounted (e.g., stacked, etc.) on an example second bottom die 238. In the illustrated example of FIG. 2A, the second bottom die 238 includes the first base 208 of FIG. 2A and the first circuitry 212 of FIG. 2A. The second bottom die 238 of FIG. 2B is similar to the first bottom die 202 of FIG. 2A, except that the second bottom die 238 includes an example third transistor layer 240. The third transistor layer 240 is similar to the first transistor layer 210 of FIG. 2A, except that the third transistor layer 240 is spaced from the first base 208. That is, unlike the first transistor layer 210 of FIG. 2A, the third transistor layer 240 is positioned within the first circuitry 212 of FIG. 2. In some examples, the third transistor layer 240 is manufactured via back end of line (BEOL) manufacturing processes.

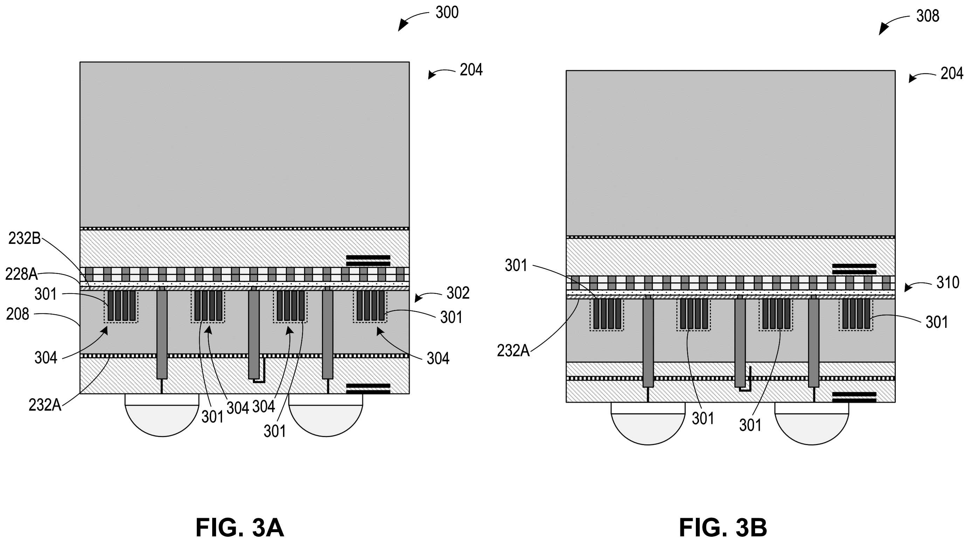

FIG. 3A is a cross-sectional side view of a third example die stack 300 including example deep trench capacitors 301 that can be used with the IC package 100 of FIG. 1. The third die stack 300 can implement the die stack 108 of FIG. 1. The third die stack 300 is similar to the first die stack 200 of FIG. 2A, except that the first top die 204 is mounted (e.g., stacked, etc.) on an example third bottom die 302. The third bottom die 302 of FIG. 3A is similar to the first bottom die 202 of FIG. 2A, except that the third bottom die 302 includes the deep trench capacitors 301. In the illustrated example of FIG. 3A, the third bottom die 302 includes the first base 208 of FIG. 2A, which includes the first front surface 232A and the first back surface 232B.

In the illustrated example of FIG. 3, each of the deep trench capacitors 301 is disposed in a corresponding one of an example openings 304 (e.g., a corresponding plurality of cavities, a corresponding plurality of holes, etc.). Each of the deep trench capacitor 301 includes structures for a capacitor fabricated on a semiconductor (e.g., silicon) substrate. Thus, each of the deep trench capacitors 301 is an example semiconductor die embedded in the openings 304. The deep trench capacitors 301 are disposed in the first back surface 232B of the first top die 204. In the illustrated example of FIG. 3A, the tops of each of the deep trench capacitors 301 are approximately flush with the first back surface 232B of the third bottom die 302. In some examples, the deep trench capacitors 301 are fabricated and subsequently deposited in the openings 304 (e.g., via a pick and place technique, etc.). In other examples, the deep trench capacitors 301 are fabricated within the openings 304 (e.g., via lithography, via electroplating, etc.).

Like the RDL MIM capacitor layer 230 of FIGS. 2A and 2B, the deep trench capacitors 301 provide power delivery, power storage, filtering, and/or other capacitor functionality to the first top die 204. In some examples, the positioning of the deep trench capacitors 301 enables the first top die 204 access capacitance that is not routed through the vias 224A, 224B, 224C. That is, like the RDL MIM capacitor layer 230 of FIGS. 2A and 2B, the deep trench capacitors 301 offer comparatively lower impedance losses for the first top die 204 than capacitors on the first front surface 232A of the first bottom die 202. Accordingly, the deep trench capacitors 301 enable the first top die 204 to have comparatively greater power demands without high impedance losses when compared to the top die of prior die stacks.

In the illustrated example of FIG. 3A, the openings 304 extend partially through the first base 208 (e.g., the openings 304 are blind holes, etc.). In the illustrated example of FIG. 3A, each of the deep trench capacitors 301 has a thickness that is approximately equal to the depth of the openings 304. In other examples, the openings 304 are through holes (e.g., extend through the first base 208, extend between the first front surface 232A and the first back surface 232B, etc.). In some such examples,
the deep trench capacitors 301 have a same thickness as the first base 208. In other examples, the deep trench capacitors 301 are disposed on one or more spacers (e.g., pedestals, etc.) within the openings 304 to facilitate alignment of the tops of the deep trench capacitors 301 and the first back surface 232B.

In the illustrated example of FIG. 3A, the first base 208 of the third bottom die 302 includes three deep trench capacitors (e.g., the deep trench capacitors 301, etc.). In other examples, the third bottom die 302 can include a different number of deep trench capacitors (e.g., one deep trench capacitor, two deep trench capacitors, five deep trench capacitors, etc.). In some examples, multiple deep trench capacitors can be positioned within a single one of the openings 304.

FIG. 3B is a cross-sectional side view of a fourth example die stack 308 including the deep trench capacitors 301 of FIG. 3A that can be used with the IC package 100 of FIG. 1. The fourth die stack 308 can implement the die stack 108 of FIG. 1. The fourth die stack 308 is similar to the third die stack 300 of FIG. 2A, except that the first top die 204 is mounted (e.g., stacked, etc.) on an example fourth bottom die 310. In the illustrated example of FIG. 3B, the fourth bottom die 310 includes the first base 208 of FIGS. 2A and 2B, the circuitry 212 of FIGS. 2A and 2B, and the deep trench capacitors 301 of FIG. 3A. The fourth bottom die 310 of FIG. 3B is similar to the third bottom die 302 of FIG. 3A, except that the fourth bottom die 310 includes the third transistor layer 240 of FIG. 2B. That is, the fourth bottom die 310 includes a transistor layer (e.g., the third transistor layer 240, etc.) that is spaced from the first front surface 232A and is positioned in the first circuitry 212 of the fourth bottom die 310.

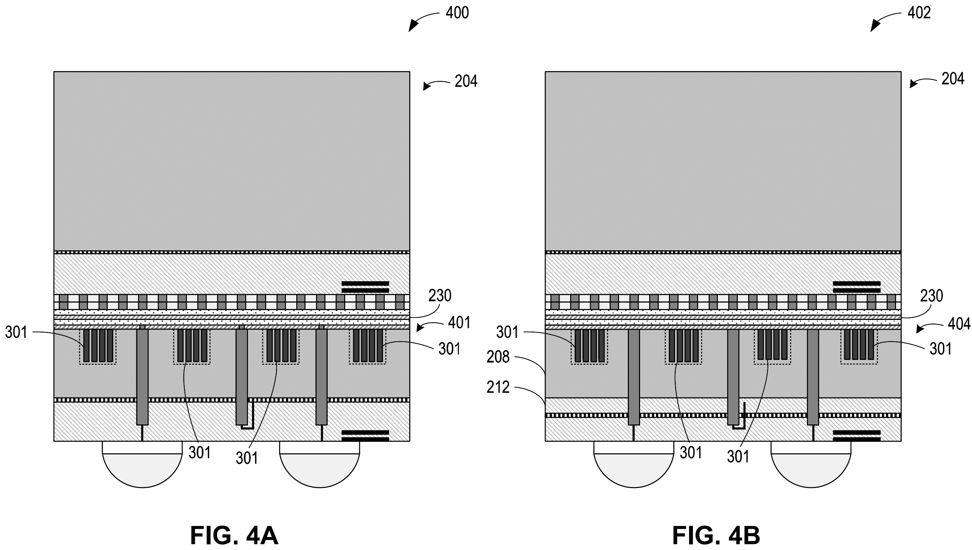

FIG. 4A is a cross-sectional side view of a fifth example die stack 400 that can be used with the IC package 100 of FIG. 1. The fifth die stack 400 is similar to the first die stack 200 of FIG. 2A, except that the fifth die stack 400 additionally includes an example fifth bottom die 401. The fifth bottom die 401 includes the RDL MIM capacitor layer 230 of FIGS. 2A and 2B and the deep trench capacitors 301 of FIGS. 3A and 3B. That is, the first top die 204 of the fifth die stack 400 is provided capacitor functionality by both the RDL MIM capacitor layer 230 of FIGS. 2A and 2B and the deep trench capacitors 301 of FIGS. 3A and 3B. FIG. 4B. In the illustrated example of FIG. 4A, the deep trench capacitors 301 are vertically below the RDL MIM capacitor layer 230 (e.g., the capacitors of the deep trench capacitors 301 are vertically below the capacitor(s) of the RDL MIM capacitor layer 230, etc.).

FIG. 4B is a cross-sectional side view of a sixth example die stack 402 including the RDL MIM capacitor layer 230 of FIGS. 2A and 2B and the plurality deep trench capacitor 301 of FIGS. 3A and 3B that can be used with the IC package 100 of FIG. 1. The sixth die stack 402 is similar to the fifth die stack 400 of FIG. 4A, except that the first top die 204 is mounted (e.g., stacked, etc.) on an example sixth bottom die 404. In the illustrated example of FIG. 3B, the sixth die stack 402 includes the first base 208 of FIGS. 2A and 2B, the circuitry 212 of FIGS. 2A and 2B, the RDL MIM capacitor layer 230 of FIGS. 2A, 2B, and 4A, the third transistor layer 240 of FIGS. 2B and 3B, and the deep trench capacitors 301 of FIGS. 3A-4A. That is, the sixth die stack 402 includes a transistor layer (e.g., the third transistor layer 240, etc.) that is spaced from the first front surface 232A of the sixth bottom die 404.

FIG. 5 is a cross-sectional side view of a seventh example die stack 500 including an example solder bump interconnection 501 that can be used with the IC package 100 of FIG. 1. In the illustrated example of FIG. 5, the seventh die stack 500 includes an example seventh bottom die 502 and an example second top die 504. The seventh bottom die 502 and the second top die 504 are similar to the fifth bottom die 401 of FIG. 4A and the first top die 204 of FIGS. 2A-4B, except as noted otherwise. The seventh die stack 500 is similar to the fifth die stack 400 of FIG. 4A, except that the seventh bottom die 502 is coupled to the second top die 504 via the solder ball interconnect 501.

In the illustrated example of FIG. 5, the seventh bottom die 502 includes example first pads 506. In the illustrated example of FIG. 5, the top die 504 includes example second pads 508, which are coupled to the first pads 506 via example solder balls 510. As used herein, the pads 506, 508 are also referred to herein as "lands." The solder balls 510 are conductive balls (e.g., bumps, etc.) of solder that electrically and physically couple the second top die 504 and the seventh bottom die 502. In the illustrated example of FIG. 5, electrical signals and/or power transmitted between the second top die 504 and the seventh bottom die 502 are transmitted via the solder balls 510. The solder bump interconnection 501 can be used in conjunction with the first die stack 200 of FIG. 2A, the second die stack 236 of FIG. 2B, the third die stack 300 of FIG. 3A, the fourth die stack 308, the fifth die stack 400 of FIG. 4A, and/or the sixth die stack 402 of FIG. 4B.

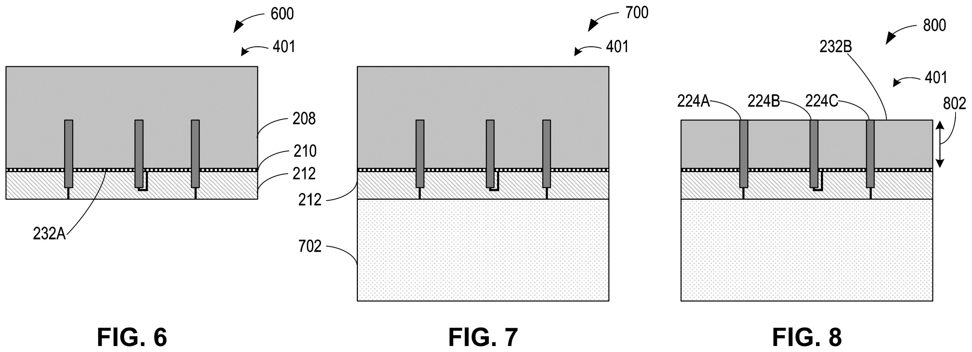

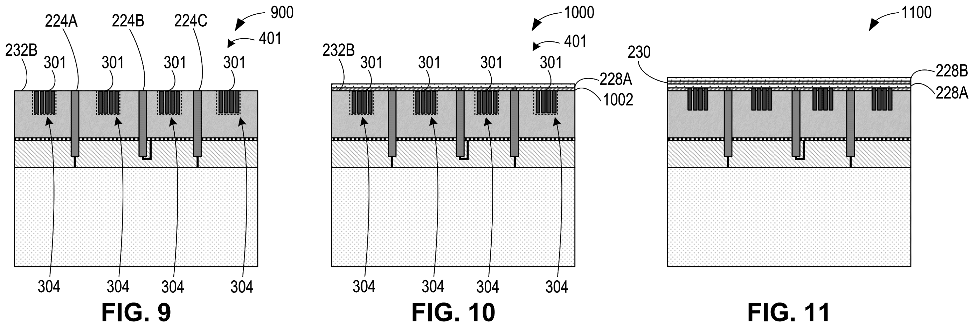

FIGS. 6, 7, 8, 9, 10, 11, 12, 13, and 14 are cross-sectional views depicting the die stack 400 of FIG. 4A in various stages of an example manufacturing process. While FIGS. 6-14 depict one process for manufacturing the fifth die stack 400, other processes and/or intermediate stages can be used to manufacture the fifth die stack 400 of FIG. 4A. The first die stack 200 of FIG. 2A, the second die stack 236 of FIG. 2B, the third die stack 300 of FIG. 3A, the fourth die stack 308, and the sixth die stack 402 of FIG. 4B can be manufactured by some or all of the intermediate stages of FIGS. 6-14. For example, the first die stack 200 of FIG. 2A and/or the second die stack 236 of FIG. 2B can be fabricated by omitting the intermediate stages of FIG. 9. For example, the fifth die stack 400 of FIG. 4A, and/or the sixth die stack 402 of FIG. 4B can be fabricated by omitting the intermediate stages of FIG. 11.

FIG. 6 is a cross-sectional schematic view of an example first intermediate stage 600 of the assembly/manufacturing of the fifth die stack 400 of FIG. 2. During the first intermediate stage 600, the fifth bottom die 401 is received and oriented such that the first circuitry 212 and the first transistor layer 210 are oriented vertically downward. That is, the first front surface 232A of the first base 208 of the fifth bottom die 401 is oriented to be closer to the package substrate to which fifth the die stack 400 is to be mounted. In some examples, the fifth bottom die 401 and the first top die 204 (not illustrated in FIG. 6) are prepared prior to the first intermediate stage 600. For example, the dies 204, 401 can be prepared via wafer-level manufacturing processes and subsequent singulation. In other examples, the dies 204, 401 are singulated from a wafer and the first circuitry 212 and the first transistor layer 210 are subsequently formed thereon. In the illustrated example of FIG. 6A, the first transistor layer 210 is formed via FEOL processes. In other examples, the first transistor layer 210 is formed via BEOL processes (e.g., the second die stack 236 of FIG. 2B is being fabricated, the fourth die stack 308 of FIG. 3B is being fabricated, the sixth die stack 402 of FIG. 4B is being fabricated, etc.).

FIG. 7 is a cross-sectional schematic view of an example second intermediate stage 700 of the assembly/manufacturing of the fifth die stack 400 of FIG. 4A. In some examples, the second intermediate stage 700 occurs after the first intermediate stage 600 of FIG. 6. During the second intermediate stage 700, an example carrier 702 is bonded to the bottom of the fifth bottom die 401. The carrier 702 is a rigid component that supports the dies 204, 401 during the fabrication of the fifth die stack 400. The carrier 702 can include (e.g., is composed of, etc.) any rigid suitable material (e.g., epoxy-based prepreg, glass, silicon, germanium, selenium, tellurium, etc.). In some examples, the carrier 702 is bonded to the fifth bottom die 401 via fusion bonding (e.g., between a silica layer of the carrier 702 and the bottom surface of the fifth bottom die 401, etc.). In other examples, the carrier 702 is bonded to the fifth bottom die 401 via a different bonding process (e.g., surface-activated bonding, plasma-activated bonding, anodic bonding, eutectic bonding, etc.). In other examples, the carrier 702 is bonded to the fifth bottom die 401 via an adhesive.

FIG. 8 is a cross-sectional schematic view of an example third intermediate stage 800 of the assembly/manufacturing of the fifth die stack 400 of FIG. 4A. In some examples, the third intermediate stage 800 occurs after the second intermediate stage 700 of FIG. 7. During the third intermediate stage 800, the first base 208 of the fifth bottom die 401 is planarized to example thickness 802, which is the thickness of the first base 208 in the fifth die stack 400 at the conclusion of fabrication. In the illustrated example of FIG. 8, the planarization of the base 208 reveals the vias 224A, 224B, 224C on the first back surface 232B. In some examples, the first base 208 is planarized via chemical mechanical polishing. In other examples, the first base 208 can be planarized via a different process.

FIG. 9 is a cross-sectional schematic view of an example fourth intermediate stage 900 of the assembly/manufacturing of the fifth die stack 400 of FIG. 4A. In some examples, the fourth intermediate stage 900 occurs after the third intermediate stage 800 of FIG. 8. During the fourth intermediate stage 900, the deep trench capacitors 301 are deposited in the first back surface 232B of the fifth bottom die 401. In some examples, the openings 304 are patterned in the first back surface 232B between the third intermediate stage 800 and the fourth intermediate stage 900. In other examples, the openings 304 are patterned during the formation of the vias 224A, 224B, 224C. In some examples, the openings 304 are formed via laser drilling. In other examples, the openings 304 can be formed in any other suitable manner (e.g., lithography, mechanical drilling, etc.). In some examples, the deep trench capacitors 301 are fabricated prior to being disposed in corresponding ones of the openings 304. In other examples, the deep trench capacitors 301 are fabricated in the openings 304 (e.g., via the repeated deposition of materials associated with the deep trench capacitors, etc.). In the illustrated example of FIG. 9, the deep trench capacitors 301 are positioned in the openings 304 such that the tops of the deep trench capacitors 301 are flush with the first back surface 232B. In some examples, after the deposition of the deep trench capacitors 301 within the openings 304, the remaining volume of the openings 304 are filled with a dielectric material (e.g., an epoxy, etc.). In some such examples, the dielectric material is deposited into the openings 304 via jetting.

FIG. 10 is a cross-sectional schematic view of an example fifth intermediate stage 1000 of the assembly/manufacturing of the fifth die stack 400 of FIG. 4A. In some examples, the fifth intermediate stage 1000 occurs after the fourth intermediate stage 900 of FIG. 9. During the fifth intermediate stage 1000, the first redistribution layer 228A is deposited on the first back surface 232B. The first redistribution layer 228A includes (e.g., are composed of, etc.) a dielectric material, such as ABF, and a conductive material, such as copper. In some examples, the first redistribution layer 228A has been patterned such that the conductive material of the first redistribution layer 228A is electrically coupled to the vias 224A, 224B, 224C and the deep trench capacitors 301. The first redistribution layer 228A can be deposited via one or more of atomic layer deposition, chemical vapor deposition, lamination, electroplating, and/or drilling.

In the illustrated example of FIG. 10, an example buffer layer 1002 is deposited on the first back surface 232B prior to the deposition of the first redistribution layer 228A. In the illustrated example of FIG. 10, the buffer layer 1002 is vertically between the first redistribution layer 228A and the first back surface 232B. In some examples, the buffer layer 1002 is an adhesive dielectric that couples the first redistribution layer 228A to the first base 208. In other examples, the buffer layer 1002 is a non-adhesive dielectric. In some examples, the buffer layer 1002 can be deposited via lamination. In other examples, the buffer layer 1002 can be deposited via any other suitable deposition technique (e.g., atomic layer deposition, chemical vapor deposition, lithography, jetting, electroplating, etc.). The buffer layer 1002 includes electrically conductive interconnects that couple the first redistribution layer 228A to the deep trench capacitors 301 and the vias 224A, 224B, 224C. In some examples, the buffer layer 1002 is absent (e.g., the first redistribution layer 228A directly contacts the first base 208, etc.). In some examples, the buffer layer 1002 is integral with the filler material in the openings 304 that surrounds the deep trench capacitors 301.

FIG. 11 is a cross-sectional schematic view of an example sixth intermediate stage 1100 of the assembly/manufacturing of the fifth die stack 400 of FIG. 4A. In some examples, the sixth intermediate stage 1100 occurs after the fifth intermediate stage 1000 of FIG. 10. During the sixth intermediate stage 1100, the RDL MIM capacitor layer 230 is deposited on the first redistribution layer 228A and the second redistribution layer 228B is deposited on the second redistribution layer 228B. In the illustrated example of FIG. 10, the RDL MIM capacitor layer 230 is disposed on the first redistribution layer 228A. In some examples, the RDL MIM capacitor layer 230 is fabricated on the first redistribution layer 228A. In some such examples, the bottom electrode(s), the dielectric layer(s), and the top electrode(s) of the RDL MIM capacitor layer 230 are deposited sequentially on the first redistribution layer 228A. In some such examples, the electrode layers of the RDL MIM capacitor layer 230 are deposited via electroplating. In other examples, the electrode layers of the RDL MIM capacitor layer 230 are deposited via another method(s) (e.g., chemical vapor deposition (CVD), atomic layer deposition (ALD), lamination, lithography, etc.). The dielectric layer(s) of the RDL MIM capacitor layer 230 can be deposited via lamination and/or TFD. In other examples, the RDL MIM capacitor layer 230 is fabricated separately and mechanically deposited on the first redistribution layer 228A (e.g., via pick and place, etc.). In some examples, the second redistribution layer 228B can be deposited on the RDL MIM capacitor layer 230 in a similar manner to the deposition of the first redistribution layer 228A in the fifth intermediate stage 1000 of FIG. 10. In other examples, the second redistribution layer 228B can deposited in any other suitable manner.

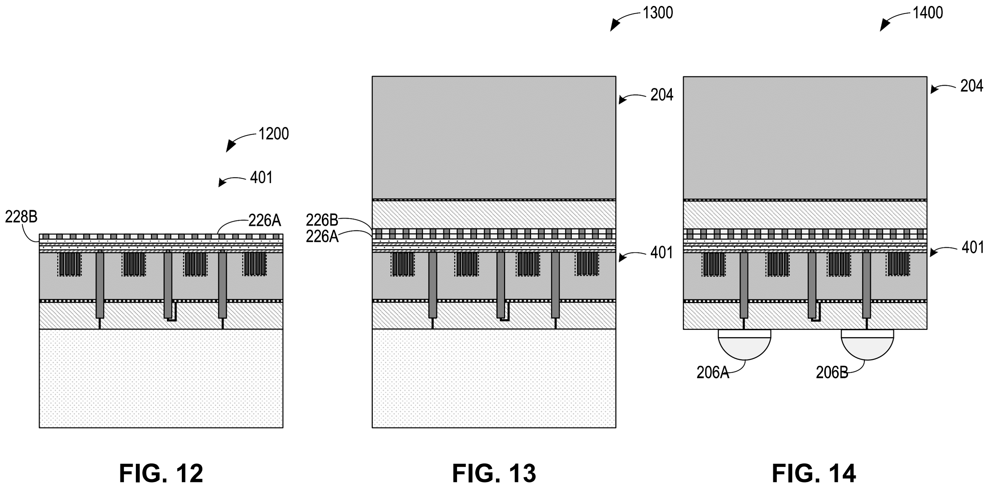

FIG. 12 is a cross-sectional schematic view of an example seventh intermediate stage 1200 of the assembly/manufacturing of the fifth die stack 400 of FIG. 4A. In some examples, the seventh intermediate stage 1200 occurs after the sixth intermediate stage 1100 of FIG. 11. During the seventh intermediate stage 1200, the first interconnect layer 226A is deposited on the second redistribution layer 228B. In the illustrated example of FIG. 12, the first interconnect layer 226A is a hybrid bonding interconnect (HBI). In some such examples, the conductive portions of the first interconnect layer 226A can be deposited via electroplating and the dielectric portions of the first interconnect layer 226A can be deposited via a physical vapor deposition and/or lamination. In some examples, after the deposition of the dielectric portions of the first interconnect layer 226A, the first interconnect layer 226A can be planarized to reveal the conductive portions of the first interconnect layer 226A. In other examples, the first interconnect layer 226A is implemented by another type of interconnection. For example, if the first interconnect layer 226A is a solder ball interconnect (e.g., the solder ball interconnect 501 of FIG. 5, etc.), the first pads 506 of the first interconnect layer 226A can be patterned on conductive portions on the second redistribution layer 228B via lithography. In some such examples, after the deposition of the first pads 506, the solder balls 510 can be deposited thereon.

FIG. 13 is a cross-sectional schematic view of an example eighth intermediate stage 1300 of the assembly/manufacturing of the fifth die stack 400 of FIG. 4A. In some examples, the eighth intermediate stage 1300 occurs after the seventh intermediate stage 1200 of FIG. 12. During the eighth intermediate stage 1300, the first top die 204 is coupled to the fifth bottom die 401 via the interconnect layers 226A, 226B. For example, if the interconnect layers 226A, 226B are HBI layers, the conductive portions of the interconnect layers 226A, 226B are aligned and the interconnect layers 226A, 226B are bonded via heat and/or pressure. In other examples, if the interconnect layers 226A, 226B are the lands of a solder ball interconnect (e.g., the solder ball interconnect 501 of FIG. 5, etc.), the lands of the first top die 204 are aligned with the balls on the lands of the fifth bottom die 401 and bonded thereto via heat (e.g., reflowing the solder balls 510, etc.). In other examples, the first top die 204 can be coupled to the fifth bottom die 401 via any other suitable manner.

FIG. 14 is a cross-sectional schematic view of an example ninth intermediate stage 1400 of the assembly/manufacturing of the fifth die stack 400 of FIG. 4A. In some examples, the ninth intermediate stage 1400 occurs after the eighth intermediate stage 1300 of FIG. 13. During the ninth intermediate stage 1400, the carrier 702 is detached from the first front surface 232A of the fifth bottom die 401. In some examples, the first circuitry 212 is cleaned after the detachment of the carrier 702.

In the illustrated example of FIG. 14, after the detachment of the carrier 702, the interconnect bumps 206A, 206B are formed on the first front surface 232A. For example, the interconnect bumps 206A, 206B can be deposited on the first front surface 232A via electroplating and lithography. In some examples, the interconnect bumps 206A, 206B are deposited on the first front surface 232A such that the interconnect bumps 206A, 206B are electrically coupled to the first via 224A and the second via 224B. In other examples, the interconnect bumps 206A, 206B can be deposited on the first front surface 232A in any other suitable manner.

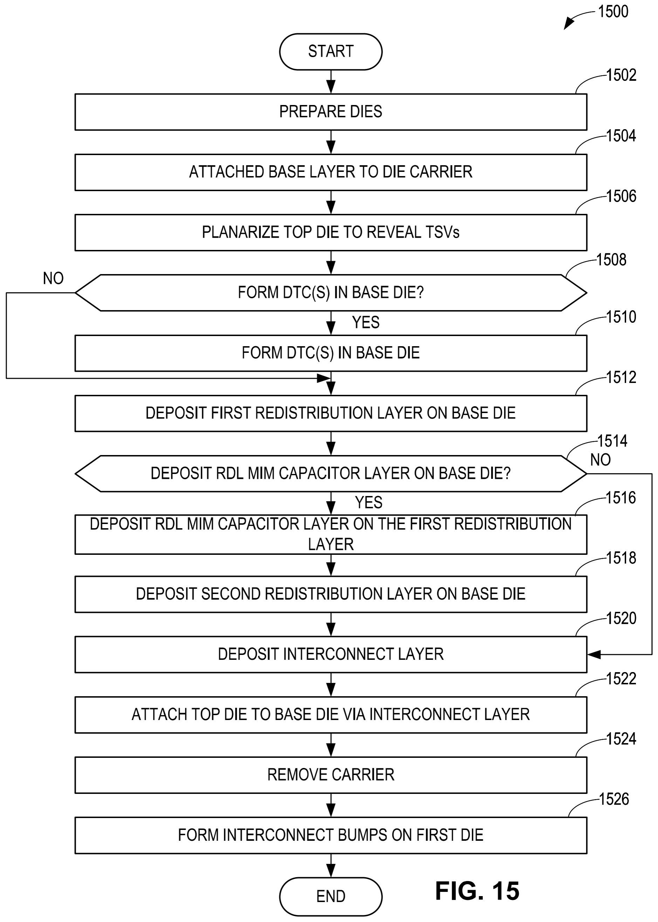

FIG. 15 is a block diagram of example operations 1500 for manufacturing the fifth die stack 400 of FIG. 4A via the intermediate stages 600, 700, 800, 900, 1000, 1100, 1200, 1300, 1400 of FIGS. 6-14. The operations 1500 can be used to manufacture the first die stack 200 of FIG. 2A, the second die stack 236 of FIG. 2B, the third die stack 300 of FIG. 3A, the fourth die stack 308, and the sixth die stack 402 of FIG. 4B.

The operations 1500 begin at block 1502 at which, the dies 204, 401 are prepared. For example, the dies 204, 401 can be prepared via wafer-level manufacturing processes and subsequent singulation. In other examples, the dies 204, 401 can be singulated from a wafer and the circuitry 212, 220 and the transistor layers 210, 218 are deposited thereon. At block 1504, the carrier 702 of FIG. 7 is bonding to the fifth bottom die 401. For example, the carrier 702 can be fusion bonded to the first circuitry 212 of the fifth bottom die 401. In other examples, the carrier 702 is bonded to the fifth bottom die 401 via a different bonding process (e.g., surface-activated bonding, plasma-activated bonding, anodic bonding, eutectic bonding, via an adhesive, etc.). The point of fabrication after completion of block 1504 corresponds to the structure of the second intermediate stage 700 of FIG. 7.

At block 1506, the first base 208 of the fifth bottom die 401 is planarized. For example, the base 208 can be planarized until the vias 224A, 224B, 224C are revealed on the first back surface 232B. In some examples, the first base 208 is planarized via chemical mechanical polishing. In other examples, the first base 208 can be planarized via a different process. The point of fabrication after completion of block 1506 corresponds to the structure of the third intermediate stage 800 of FIG. 8.

At block 1508, it is determined if deep trench capacitors 301 are to be formed in the fifth bottom die 401. For example, it can be determined if the third die stack 300, the fourth die stack 308, the fifth die stack 400, or the sixth die stack 402 are being fabricated. If the deep trench capacitors 301 are being formed in the fifth bottom die 401, the operations 1500 advance to block 1510. If the deep trench capacitors 301 are not being formed in the fifth bottom die 401, the operations 1500 advance to block 1512.

At block 1510, the deep trench capacitors 301 are disposed in the first back surface 232B of the third bottom die 302. For example, the deep trench capacitors 301 are fabrication prior to being deposited in corresponding ones of the openings 304. In other examples, the deep trench capacitors 301 are fabricated in the openings 304 (e.g., via the repeated deposition of materials associated with the deep trench capacitors, etc.). In some examples, the deep trench capacitors 301 are positioned in the openings 304 such that the tops of the deep trench capacitors 301 are flush with the first back surface 232B. In some examples, the openings 304 are formed during the execution of block 1510 (e.g., via drilling, via lithography, etc.). In other examples, the openings 304 are formed during the formation of the vias 224A, 224B, 224C in the fifth bottom die 401. In some examples, after the deposition of the deep trench capacitors 301 within the openings 304, the remaining volume of the openings 304 is filled with a dielectric material (e.g., an epoxy, etc.). In some such examples, the dielectric material is deposited into the openings 304 via jetting. The point of fabrication after completion of block 1510 corresponds to the structure of the fifth intermediate stage 1000 of FIG. 10.

At block 1512, the first redistribution layer 228A is deposited on the first back surface 232B of the first base 208 of the fifth bottom die 401. For example, the first redistribution layer 228A can be deposited via one or more of atomic layer deposition, chemical vapor deposition, lamination, electroplating, and/or drilling. In some examples, the first redistribution layer 228A includes (e.g., are composed of, etc.) a dielectric material, such as ABF, and a conductive material, such as copper. In some examples, the first redistribution layer 228A is patterned such that the conductive material of the first redistribution layer 228A is electrically coupled to the vias 224A, 224B, 224C, and the deep trench capacitors 301, if present. In some examples, the buffer layer 1002 of FIG. 10 can be deposited between the first redistribution layer 228A and the first back surface 232B of the first base 208 of the fifth bottom die 401. The point of fabrication after completion of block 1512 corresponds to the structure of the fifth intermediate stage 1000 of FIG. 10.

At block 1514, it is determined if the RDL MIM capacitor layer 230 is to be deposited on the first redistribution layer 228A. For example, it can be determined if the first die stack 200 of FIG. 2A, the second die stack 236 of FIG. 2B, the fifth die stack 400 of FIG. 4A, or the sixth die stack 402 of FIG. 4B are being fabricated. If the RDL MIM capacitor layer 230 is being deposited on the first redistribution layer, the operations 1500 advance to block 1510. If the RDL MIM capacitor layer 230 is not being formed in the fifth bottom die 401, the operations 1500 advance to block 1514.

At block 1516, the RDL MIM capacitor layer 230 is deposited on the first redistribution layer 228A. In the illustrated example of FIG. 10, the RDL MIM capacitor layer 230 is disposed on the first redistribution layer 228A. In some examples, the RDL MIM capacitor layer 230 is fabricated on the RDL MIM capacitor layer 230. In some such examples, the bottom electrode(s), the dielectric layer(s), and the top electrode(s) of the RDL MIM capacitor layer 230 are deposited sequentially on the first redistribution layer 228A. In some such examples, the electrode layers of the RDL MIM capacitor layer 230 are deposited via electroplating. In other examples, the electrode layers of the RDL MIM capacitor layer 230 are deposited via another method(s) (e.g., chemical vapor deposition (CVD), atomic layer deposition (ALD), lamination, lithography, etc.). The dielectric layer(s) of the RDL MIM capacitor layer 230 can be deposited via lamination and/or TFD. In other examples, the RDL MIM capacitor layer 230 is fabricated separately and mechanically deposited on the first redistribution layer 228A (e.g., via pick and place, etc.).

At block 1518, the second redistribution layer 228B is deposited on the RDL MIM capacitor layer 230. In some examples, the second redistribution layer 228B can be deposited on the RDL MIM capacitor layer 230 in a similar manner to the deposition of the first redistribution layer 228A during the execution of block 1512. In other examples, the second redistribution layer 228B can deposited in any other suitable manner. The point of fabrication after completion of block 1518 corresponds to the structure of the sixth intermediate stage 1100 of FIG. 11.

At block 1520, the first interconnect layer 226A is deposited. For example, the first interconnect layer 226A can be deposited on the first redistribution layer 228A (e.g., if the RDL MIM capacitor layer 230 and the second redistribution layer 228B were not deposited via the execution of blocks 1516, 1518, respectively, etc.) and/or the second redistribution layer 228B (e.g., if the RDL MIM capacitor layer 230 and the second redistribution layer 228B were deposited via the execution of blocks 1516, 1518, respectively, etc.).

For example, if the first interconnect layer 226A is a hybrid bonding interconnect (HBI), the conductive portions of the first interconnect layer 226A can be deposited via electroplating and the dielectric portions of the first interconnect layer 226A can be deposited via a physical vapor deposition and/or lamination. In some such examples, after the deposition of the dielectric portions of the first interconnect layer 226A, the first interconnect layer 226A can be planarized to reveal the conductive portions of the first interconnect layer 226A. In other examples, if the first interconnect layer 226A is a solder ball interconnect (e.g., the solder ball interconnect 501 of FIG. 5, etc.), the first pads 506 of the first interconnect layer 226A can be patterned on conductive portions on the second redistribution layer 228B via lithography. In some such examples, after the deposition of the first pads 506, the solder balls 510 can be deposited thereon. The point of fabrication after completion of block 1520 corresponds to the structure of the seventh intermediate stage 1200 of FIG. 12.

At block 1522, the first top die 204 is coupled to the fifth bottom die 401 via the interconnect layers 226A, 226B. For example, if the interconnect layers 226A, 226B are HBI layers, the conductive portions of the interconnect layers 226A, 226B are aligned and the interconnect layers 226A, 226B are bonded via heat and/or pressure. In other examples, if the interconnect layers 226A, 226B are the lands of a solder ball interconnect (e.g., the solder ball interconnect 501 of FIG. 5, etc.), the lands of the first top die 204 are aligned with the balls on the lands of the fifth bottom die 401 and bonded thereto via heat. In other examples, the first top die 204 can be coupled to the fifth bottom die 401 via any other suitable manner. The point of fabrication after completion of block 1522 corresponds to the structure of the eighth intermediate stage 1300 of FIG. 13. At block 1524, the carrier 702 is detached from the first front surface 232A of the fifth bottom die 401. In some examples, the first circuitry 212 is cleaned after the detachment of the carrier 702.

At block 1526, the interconnect bumps 206A, 206B are formed on the first front surface 232A. For example, the interconnect bumps 206A, 206B can be deposited on the first front surface 232A via electroplating and lithography. In some examples, the interconnect bumps 206A, 206B are deposited on the first front surface 232A such that the interconnect bumps 206A, 206B are electrically coupled to the first via 224A and the second via 224B. In other examples, the interconnect bumps 206A, 206B can be deposited on the first front surface 232A in any other suitable manner. The point of fabrication after completion of block 1526 corresponds to the structure of the ninth intermediate stage 1400 of FIG. 14. The operations 1500 end.

Although the example operations 1500 are described with reference to the flowchart illustrated in FIG. 15, many other methods of assembling/manufacturing the fourth die stack 400 of FIG. 4A may alternatively be used. For example, the order of execution of the blocks may be changed, and/or some of the blocks described may be changed, eliminated, or combined.

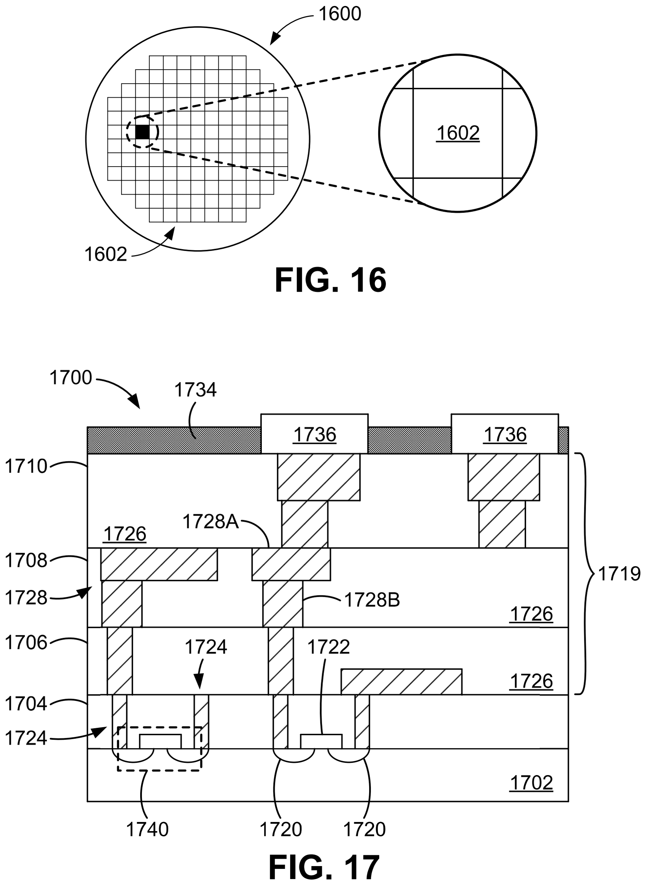

FIG. 16 is a top view of an example wafer 1600 and dies 1602 that may be included in the IC package 100 (e.g., as any suitable ones of the die 106 and/or the die stack 108, etc.). The wafer 1600 may be composed of semiconductor material and may include one or more dies 1602 having circuitry. Some or all of the dies 1602 may be a repeating unit of a semiconductor product. After the fabrication of the semiconductor product is complete, the wafer 1600 may undergo a singulation process in which the dies 1602 are separated from one another to provide discrete "chips." One or more of the dies 1602 may include one or more transistors (e.g., some of the transistors 1740 of FIG. 17, discussed below), supporting circuitry to route electrical signals to the transistors, passive components (e.g., traces, resistors, capacitors, inductors, and/or other circuitry), and/or any other components. In some examples, the dies 1602 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry. Multiple ones of these devices may be combined on a single die (e.g., a die of the dies 1602 of FIG. 16, etc.). For example, a memory array formed by multiple memory circuits may be formed on a same die (e.g., one of the dies 1602 of FIG. 16, etc.) as programmable circuitry or other logic circuitry. Such memory may store information for use by the programmable circuitry. The example IC package 100 disclosed herein may be manufactured using a die-to-wafer assembly technique in which the die 106 and/or the die stack 108, etc. are attached to a wafer 1600 that include others of the die 106 and/or the die stack 108, and the wafer 1600 is subsequently singulated.

FIG. 17 is a cross-sectional side view of an example IC device 1700 that may be included in the example IC package 100 (e.g., in any one of the die 106 and/or the die stack 108, etc.). One or more of the IC devices 1700 may be included in one or more dies 1602 (FIG. 16). The IC device 1700 may be formed on an example die substrate 1702 (e.g., the wafer 1600 of FIG. 16) and may be included in a die (e.g., a die of the dies 1602 of FIG. 16). The die substrate 1702 may be a semiconductor substrate composed of semiconductor material systems including, for example, n-type or p-type materials systems (or a combination of both). The die substrate 1702 may include, for example, a crystalline substrate formed using a bulk silicon or a silicon-on-insulator (SOI) substructure. In some examples, the die substrate 1702 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 1702. Although a few examples of materials from which the die substrate 1702 may be formed are described here, any material that may serve as a foundation for an IC device 1700 may be used. The die substrate 1702 may be part of a singulated die (e.g., the dies 1602 of FIG. 16) or a wafer (e.g., the wafer 1600 of FIG. 16).

The IC device 1700 may include one or more example device layers 1704 disposed on or above the die substrate 1702. The device layer 1704 may include features of one or more example transistors 1740 (e.g., metal oxide semiconductor field-effect transistors (MOSFETs)) formed on the die substrate 1702. The device layer 1704 may include, for example, one or more example source and/or drain (S/D) regions 1720, an example gate 1722 to control current flow between the S/D regions 1720, and one or more example S/D contacts 1724 to route electrical signals to/from the S/D regions 1720. The transistors 1740 may include additional features not depicted for the sake of clarity such as, for example, device isolation regions, gate contacts, and the like. The transistors 1740 are not limited to the type and configuration depicted in FIG. 17 and may include a wide variety of other types and/or configurations such as, for example, planar transistors, non-planar transistors, or a combination of both. Non-planar transistors may include FinFET transistors such as for example, double-gate transistors, tri-gate transistors, wrap-around gate transistor, and/or all-around gate transistors, such as nanoribbon and/or nanowire transistors.

Some or all of the transistors 1740 may include an example gate 1722 formed of at least two layers including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 1740 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included for other purposes, such as, for example, a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some examples, when viewed as a cross-section of the transistor 1740 along the source-channel-drain direction, the gate electrode may include a U-shaped structure that includes a bottom portion substantially parallel to the surface of the die substrate 1702 and two sidewall portions that are substantially perpendicular to the top surface of the die substrate 1702. In other examples, at least one of the metal layers that form the gate electrode may be a planar layer that is substantially parallel to the top surface of the die substrate 1702 and does not include sidewall portions substantially perpendicular to the top surface of the die substrate 1702. In other examples, the gate electrode may include a combination of U-shaped structures and planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers include deposition and etching process steps. In some examples, a plurality of spacer pairs may be used; for instance, two pairs, three pairs, or four pairs of sidewall spacers may be formed on opposing sides of the gate stack.

The S/D regions 1720 may be formed within the die substrate 1702 adjacent to the gate 1722 of respective ones of the transistors 1740. The S/D regions 1720 may be formed using an implantation/diffusion process or an etching/deposition process, for example. In the former process, dopants such as boron, aluminum, antimony, phosphorous, or arsenic may be ion-implanted into the die substrate 1702 to form the S/D regions 1720. An annealing process that activates the dopants and causes the dopants to diffuse farther into the die substrate 1702 may follow the ion-implantation process. In the latter process, the die substrate 1702 may first be etched to form recesses at the locations of the S/D regions 1720. An epitaxial deposition process may then be carried out to fill the recesses with material that is used to fabricate the S/D regions 1720. In some implementations, the S/D regions 1720 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 1720 may be formed using one or more alternate semiconductor materials such as germanium or a group III-V material or alloy. In further examples, one or more layers of metal and/or metal alloys may be used to form the S/D regions 1720.

Electrical signals, such as power and/or input/output (I/O) signals, may be routed to and/or from the devices (e.g., transistors 1740) of the device layer 1704 through one or more example interconnect layers disposed on the device layer 1704 (illustrated in FIG. 17 as interconnect layers 1706-1710). For example, electrically conductive features of the device layer 1704 (e.g., the gate 1722 and the S/D contacts 1724) may be electrically coupled with example interconnect structures 1728 of the interconnect layers 1706-1710. The one or more interconnect layers 1706-1710 may form an example metallization stack (also referred to as an "ILD stack") 1719 of the IC device 1700.

The interconnect structures 1728 may be arranged within the interconnect layers 1706-1710 to route electrical signals according to a wide variety of designs (in particular, the arrangement is not limited to the particular configuration of interconnect structures 1728 depicted in FIG. 17). Although a particular number of interconnect layers 1706-1710 is depicted in FIG. 17, examples of the present disclosure include IC devices having more or fewer interconnect layers than depicted.

In some examples, the interconnect structures 1728 may include example lines 1728A and/or example vias 1728B filled with an electrically conductive material such as a metal. The lines 1728A may be arranged to route electrical signals in a direction of a plane that is substantially parallel with a surface of the die substrate 1702 upon which the device layer 1704 is formed. For example, the lines 1728A may route electrical signals in a direction in and out of the page from the perspective of FIG. 17. The vias 1728B may be arranged to route electrical signals in a direction of a plane that is substantially perpendicular to the surface of the die substrate 1702 upon which the device layer 1704 is formed. In some examples, the vias 1728B may electrically couple lines 1728A of different interconnect layers 1706-1710 together.

The interconnect layers 1706-1710 may include an example dielectric material 1726 disposed between the interconnect structures 1728, as shown in FIG. 17. In some examples, the dielectric material 1726 disposed between the interconnect structures 1728 in different ones of the interconnect layers 1706-1710 may have different compositions. In other examples, the composition of the dielectric material 1726 between different interconnect layers 1706-1710 may be the same.

A first interconnect layer 1706 (referred to as Metal 1 or "M1") may be formed directly on the device layer 1704. In some examples, the first interconnect layer 1706 may include lines 1728A and/or vias 1728B, as shown. The lines 1728A of the first interconnect layer 1706 may be coupled with contacts (e.g., the S/D contacts 1724) of the device layer 1704.

A second interconnect layer 1708 (referred to as Metal 2 or "M2") may be formed directly on the first interconnect layer 1706. In some examples, the second interconnect layer 1708 may include vias 1728B to couple the lines 1728A of the second interconnect layer 1708 with the lines 1728A of the first interconnect layer 1706. Although the lines 1728A and the vias 1728B are structurally delineated with a line within each interconnect layer (e.g., within the second interconnect layer 1708) for the sake of clarity, the lines 1728A and the vias 1728B may be structurally and/or materially contiguous (e.g., simultaneously filled during a dual-damascene process) in some examples.

A third interconnect layer 1710 (referred to as Metal 3 or "M3") (and additional interconnect layers, as desired) may be formed in succession on the second interconnect layer 1708 according to similar techniques and configurations described in connection with the second interconnect layer 1708 and/or the first interconnect layer 1706. In some examples, the interconnect layers that are "higher up" in the metallization stack 1719 in the IC device 1700 (i.e., further away from the device layer 1704) may be thicker.

The IC device 1700 may include an example solder resist material 1734 (e.g., polyimide or similar material) and one or more example conductive contacts 1736 formed on the interconnect layers 1706-1710. In FIG. 17, the conductive contacts 1736 are illustrated as taking the form of bond pads. The conductive contacts 1736 may be electrically coupled with the interconnect structures 1728 and configured to route the electrical signals of the transistor(s) 1740 to other external devices. For example, solder bonds may be formed on the one or more conductive contacts 1736 to mechanically and/or electrically couple a chip including the IC device 1700 with another component (e.g., a circuit board). The IC device 1700 may include additional or alternate structures to route the electrical signals from the interconnect layers 1706-1710; for example, the conductive contacts 1736 may include other analogous features (e.g., posts) that route the electrical signals to external components.

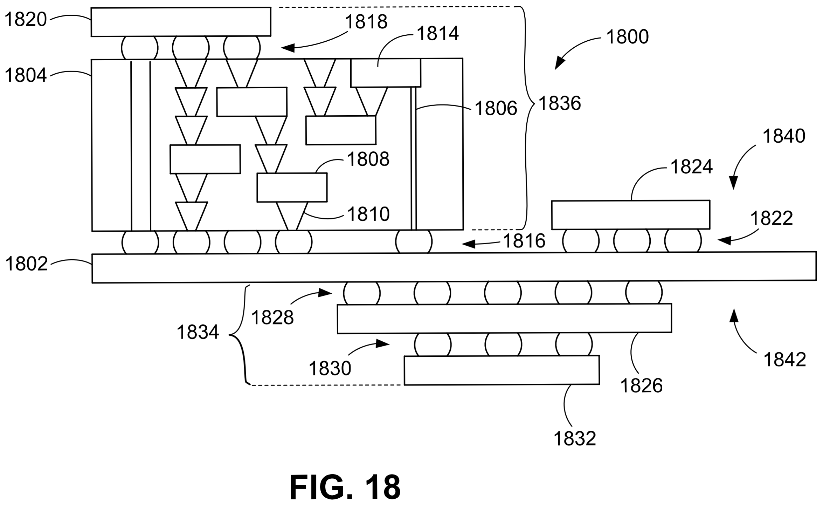

FIG. 18 is a cross-sectional side view of an example IC device assembly 1800 that may include the IC package 100 disclosed herein. In some examples, the IC device assembly corresponds to the IC package 100. The IC device assembly 1800 includes a number of components disposed on an example circuit board 1802 (which may be, for example, a motherboard). The IC device assembly 1800 includes components disposed on an example first face 1840 of the circuit board 1802 and an example opposing second face 1842 of the circuit board 1802. Any of the IC packages discussed herein with reference to the IC device assembly 1800 may take the form of the example IC package 100.

In some examples, the circuit board 1802 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1802. In other examples, the circuit board 1802 may be a non-PCB substrate. In some examples, the circuit board 1802 may be, for example, the circuit board 102 of FIG. 1.

The IC device assembly 1800 illustrated in FIG. 18 includes an example package-on-interposer structure 1836 coupled to the first face 1840 of the circuit board 1802 by example coupling components 1816. The coupling components 1816 may electrically and mechanically couple the package-on-interposer structure 1836 to the circuit board 1802, and may include solder balls (as shown in FIG. 18), male and female portions of a socket, an adhesive, an underfill material, and/or any other suitable electrical, chemical, and/or mechanical coupling structure.

The package-on-interposer structure 1836 may include an example IC package 1820 coupled to an example interposer 1804 by example coupling components 1818. The coupling components 1818 may take any suitable form for the application, such as the forms discussed above with reference to the coupling components 1816. Although a single IC package 1820 is shown in FIG. 18, multiple IC packages may be coupled to the interposer 1804. Additionally or alternatively, in some examples, additional interposers may be coupled to the interposer 1804. The interposer 1804 may provide an intervening substrate used to bridge the circuit board 1802 and the IC package 1820. The IC package 1820 may be or include, for example, a die (e.g., a die of the dies 1602 of the dies of FIG. 16), an IC device (e.g., the IC device 1700 of FIG. 17), and/or any other suitable component(s). Generally, the interposer 1804 may spread a connection to a wider pitch or reroute a connection to a different connection. For example, the interposer 1804 may couple the IC package 1820 (e.g., a die) to a set of BGA conductive contacts of the coupling components 1816 for coupling to the circuit board 1802. In the example illustrated in FIG. 18, the IC package 1820 and the circuit board 1802 are attached to opposing sides of the interposer 1804. In other examples, the IC package 1820 and the circuit board 1802 may be attached to a same side of the interposer 1804. In some examples, three or more components may be interconnected by way of the interposer 1804.

In some examples, the interposer 1804 may be formed as a PCB, including multiple metal layers separated from one another by layers of dielectric material and interconnected by electrically conductive vias. In some examples, the interposer 1804 may be formed of an epoxy resin, a fiberglass-reinforced epoxy resin, an epoxy resin with inorganic fillers, a ceramic material, or a polymer material such as polyimide. In some examples, the interposer 1804 may be formed of alternate rigid or flexible materials that may include the same materials described above for use in a semiconductor substrate, such as silicon, germanium, and other group III-V and group IV materials. The interposer 1804 may include example metal interconnects 1808 and example vias 1810, including but not limited to example through-silicon vias (TSVs) 1806. The interposer 1804 may further include example embedded devices 1814, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1804. The package-on-interposer structure 1836 may take the form of any of the package-on-interposer structures known in the art.

The IC device assembly 1800 may include an example IC package 1824 coupled to the first face 1840 of the circuit board 1802 by example coupling components 1822. The coupling components 1822 may take the form of any of the examples discussed above with reference to the coupling components 1816, and the IC package 1824 may take the form of any of the examples discussed above with reference to the IC package 1820.

The IC device assembly 1800 illustrated in FIG. 18 includes an example package-on-package structure 1834 coupled to the second face 1842 of the circuit board 1802 by coupling components 1828. The package-on-package structure 1834 may include a first example IC package 1826 and a second example IC package 1832 coupled together by example coupling components 1830 such that the first IC package 1826 is disposed between the circuit board 1802 and the second IC package 1832. The coupling components 1828, 1830 may take the form of any of the examples of the coupling components 1816 discussed above, and the IC packages 1826, 1832 may take the form of any of the examples of the IC package 1820 discussed above.

The IC device assembly 1800 illustrated in FIG. 18 includes an example package-on-package structure 1834 coupled to the second face 1842 of the circuit board 1802 by coupling components 1828. The package-on-package structure 1834 may include a first example IC package 1826 and a second example IC package 1832 coupled together by example coupling components 1830 such that the first IC package 1826 is disposed between the circuit board 1802 and the second IC package 1832. The coupling components 1828, 1830 may take the form of any of the examples of the coupling components 1816 discussed above, and the IC packages 1826, 1832 may take the form of any of the examples of the IC package 1820 discussed above.

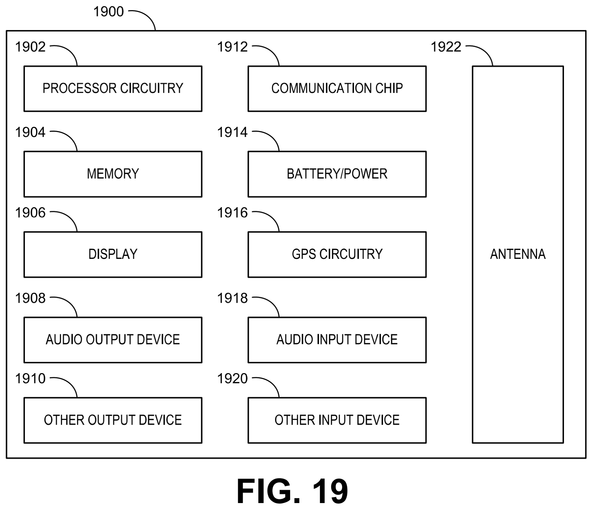

FIG. 19 is a block diagram of an example electrical device 1900 that may include one or more of the example IC package 100. For example, any suitable ones of the components of the electrical device 1900 may include one or more of the device assemblies 1800, IC devices 1700, or dies 1602 disclosed herein, and may be arranged in the example IC package 100. A number of components are illustrated in FIG. 19 as included in the electrical device 1900, but any one or more of these components may be omitted or duplicated, as suitable for the application. In some examples, some or all of the components included in the electrical device 1900 may be attached to one or more motherboards. In some examples, some or all of these components are fabricated onto a single system-on-a-chip (SoC) die.

Additionally, in some examples, the electrical device 1900 may not include one or more of the components illustrated in FIG. 19, but the electrical device 1900 may include interface circuitry for coupling to the one or more components. For example, the electrical device 1900 may not include an example display 1906, but may include display interface circuitry (e.g., a connector and driver circuitry) to which the display 1906 may be coupled. In some examples, the electrical device 1900 may not include an example audio input device 1918 (e.g., microphone) or an example audio output device 1908 (e.g., a speaker, a headset, earbuds, etc.), but may include audio input or output device interface circuitry (e.g., connectors and supporting circuitry) to which the audio input device 1918 or the audio output device 1908 may be coupled.

The electrical device 1900 may include example programmable or processor circuitry 1902 (e.g., one or more processing devices). The processor circuitry 1902 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The electrical device 1900 may include an example memory 1904, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 1904 may include memory that shares a die with the processor circuitry 1902. This memory may be used as cache memory and may include embedded dynamic random access memory (eDRAM) or spin transfer torque magnetic random access memory (STT-MRAM).

In some examples, the electrical device 1900 may include an example communication chip 1912 (e.g., one or more communication chips). For example, the communication chip 1912 may be configured for managing wireless communications for the transfer of data to and from the electrical device 1900. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 1912 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1912 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1912 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1912 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1912 may operate in accordance with other wireless protocols in other examples. The electrical device 1900 may include an example antenna 1922 to facilitate wireless communications and/or to receive other wireless communications (such as AM or FM radio transmissions).

In some examples, the communication chip 1912 may manage wired communications, such as electrical, optical, or any other suitable communication protocols (e.g., the Ethernet). As noted above, the communication chip 1912 may include multiple communication chips. For instance, a first communication chip 1912 may be dedicated to shorter-range wireless communications such as Wi-Fi or Bluetooth, and a second communication chip 1912 may be dedicated to longer-range wireless communications such as global positioning system (GPS), EDGE, GPRS, CDMA, WiMAX, LTE, EV-DO, or others. In some examples, a first communication chip 1912 may be dedicated to wireless communications, and a second communication chip 1912 may be dedicated to wired communications.

The electrical device 1900 may include example battery/power circuitry 1914. The battery/power circuitry 1914 may include one or more energy storage devices (e.g., batteries or capacitors) and/or circuitry for coupling components of the electrical device 1900 to an energy source separate from the electrical device 1900 (e.g., AC line power).

The electrical device 1900 may include the display 1906 (or corresponding interface circuitry, as discussed above). The display 1906 may include any visual indicators, such as a heads-up display, a computer monitor, a projector, a touchscreen display, a liquid crystal display (LCD), a light-emitting diode display, or a flat panel display.

The electrical device 1900 may include the audio output device 1908 (or corresponding interface circuitry, as discussed above). The audio output device 1908 may include any device that generates an audible indicator, such as speakers, headsets, or earbuds.

The electrical device 1900 may include the audio input device 1918 (or corresponding interface circuitry, as discussed above). The audio input device 1918 may include any device that generates a signal representative of a sound, such as microphones, microphone arrays, or digital instruments (e.g., instruments having a musical instrument digital interface (MIDI) output).

The electrical device 1900 may include example GPS circuitry 1916. The GPS circuitry 1916 may be in communication with a satellite-based system and may receive a location of the electrical device 1900, as known in the art.

The electrical device 1900 may include any other example output device 1910 (or corresponding interface circuitry, as discussed above). Examples of the other output device 1910 may include an audio codec, a video codec, a printer, a wired or wireless transmitter for providing information to other devices, and/or an additional storage device.

The electrical device 1900 may include any other example input device 1920 (or corresponding interface circuitry, as discussed above). Examples of the other input device 1920 may include an accelerometer, a gyroscope, a compass, an image capture device, a keyboard, a cursor control device such as a mouse, a stylus, a touchpad, a bar code reader, a Quick Response (QR) code reader, any sensor, and/or a radio frequency identification (RFID) reader.

The electrical device 1900 may have any desired form factor, such as, for example, a hand-held or mobile electrical device (e.g., a cell phone, a smart phone, a mobile internet device, a music player, a tablet computer, a laptop computer, a netbook computer, an ultrabook computer, a personal digital assistant (PDA), an ultra-mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device (e.g., a smartwatch, a ring, googles, a headset, glasses, etc.). In some examples, the electrical device 1900 may be any other electronic device that processes data.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities, etc., the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities, etc., the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements, or actions may be implemented by, e.g., the same entity or object. Additionally, although individual features may be included in different examples or claims, these may possibly be combined, and the inclusion in different examples or claims does not imply that a combination of features is not feasible and/or advantageous.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "approximately" and "about" modify their subjects/values to recognize the potential presence of variations that occur in real world applications. For example, "approximately" and "about" may modify dimensions that may not be exact due to manufacturing tolerances and/or other real world imperfections as will be understood by persons of ordinary skill in the art. For example, "approximately" and "about" may indicate such dimensions may be within a tolerance range of +/- 10% unless otherwise specified herein.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example an integrated circuit may be implemented as one or more of an ASIC, an FPGA, a chip, a microchip, programmable circuitry, a semiconductor substrate coupling multiple circuit elements, a system on chip (SoC), etc.

From the foregoing, it will be appreciated that example systems, apparatus, articles of manufacture, and methods have been disclosed that provide capacitors on a back surface of a bottom die of a F2B 3DIC. Examples disclosed herein provide enhanced power delivery and/or other capacitor functionality to the top dies of the F2B 3DIC with reduced impedance losses compared to known structures. Disclosed systems, apparatus, articles of manufacture, and methods improve the efficiency of using a computing device by enabling F2B 3DIC to have top dies with greater performance, capacitance, and power demands when compared to prior F2B 3DICs. Disclosed systems, apparatus, articles of manufacture, and methods are accordingly directed to one or more improvement(s) in the operation of a machine such as a computer or other electronic and/or mechanical device.

Semiconductor packages including die stacks with capacitors and related methods are disclosed herein. Further examples and combinations thereof include the following:
Example 1 includes an apparatus including a package substrate, a first chip including a first surface adjacent to the package substrate, a second surface distal to the package substrate, a capacitor adjacent to the second surface, and circuitry on the first surface, and a second chip in a stack with the first chip, the second chip on the second surface, the second chip electrically coupled to the capacitor.
Example 2 includes the apparatus of any preceding example, including a transistor layer spaced from the first surface.
Example 3 includes the apparatus of any preceding example, wherein the capacitor is a deep trench capacitor in the second surface.
Example 4 includes the apparatus of any preceding example, wherein the first chip includes a redistribution layer on the second surface, the capacitor in the redistribution layer.
Example 5 includes the apparatus of any preceding example, wherein the redistribution layer is a first redistribution layer and the apparatus includes a second redistribution layer, the capacitor between the first redistribution layer and the second redistribution layer.
Example 6 includes the apparatus of any preceding example, wherein the capacitor is a first capacitor and the first die includes a second capacitor below the first capacitor.
Example 7 includes the apparatus of any preceding example, wherein the first chip is coupled to the second chip via a hybrid bonded interface.
Example 8 includes an apparatus including a base including a first surface, and a second surface opposite the first surface, circuitry on the first surface, a connector to couple the circuitry to a package substrate, an interconnect layer on the second surface, the interconnect layer to couple the circuitry to a second chip, and a capacitor adjacent to the interconnect layer.
Example 9 includes the apparatus of any preceding example, wherein the base includes an opening in the second surface and the capacitor is in the opening.
Example 10 includes the apparatus of any preceding example, including a redistribution layer between the interconnect layer and the second surface the capacitor is on the redistribution layer.
Example 11 includes the apparatus of any preceding example, wherein the capacitor is a metal-insulator-metal capacitor.
Example 12 includes the apparatus of any preceding example, wherein the capacitor is a first capacitor and including a deep trench capacitor below the redistribution layer.
Example 13 includes the apparatus of any preceding example, wherein the interconnect layer includes a solder bump.
Example 14 includes the apparatus of any preceding example, including a transistor layer on the first surface, the transistor layer spaced from the base.
Example 15 includes the apparatus of any preceding example, including a second die mounted on the interconnect layer.
Example 16 includes the apparatus of any preceding example, wherein the second die is electrically coupled to the capacitor.
Example 17 includes a method including preparing a first die including circuitry on a first surface, disposing a capacitor adjacent to a second surface of the first die, the second surface opposite the first surface, and mounting a second die on the second surface of the first die, the second die electrically coupled to the capacitor.
Example 18 includes the method of any preceding example, wherein the disposing of the capacitor adjacent to the second surface of the first die includes patterning an opening in the second surface, and depositing a capacitor in the opening.
Example 19 includes the method of any preceding example, wherein the disposing of the capacitor adjacent to the second surface of the first die includes depositing a redistribution layer on the first surface, and depositing a capacitor layer on the redistribution layer, the capacitor layer including the capacitor.
Example 20 includes the method of any preceding example, wherein the redistribution layer is a first redistribution layer and including depositing a second redistribution layer on the capacitor layer, and depositing an interconnect layer on the second redistribution layer.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An apparatus including:
a package substrate;
a first chip including:
a first surface adjacent to the package substrate;
a second surface distal to the package substrate;
a capacitor adjacent to the second surface; and
circuitry on the first surface; and
a second chip in a stack with the first chip, the second chip on the second surface, the second chip electrically coupled to the capacitor.

2. The apparatus of claim 1, including a transistor layer spaced from the first surface.

3. The apparatus of any one of claims 1-2, wherein the capacitor is a deep trench capacitor in the second surface.

4. The apparatus of any one of claims 1-2, wherein the capacitor is a metal-insulator-metal capacitor.

5. The apparatus of any one of claims 1-4, wherein the first chip includes a redistribution layer on the second surface, the capacitor in the redistribution layer.

6. The apparatus of claim 5, wherein the redistribution layer is a first redistribution layer and the apparatus includes a second redistribution layer, the capacitor between the first redistribution layer and the second redistribution layer.

7. The apparatus of any one of claims 5-6, wherein the capacitor is a first capacitor and the first chip includes a second capacitor below the first capacitor.

8. The apparatus of any one of claims 1-7, wherein the first chip is coupled to the second chip via a hybrid bonded interface.

9. The apparatus of any one of claims 1-8, including an interconnect layer adjacent the second surface, the interconnect layer to couple the circuitry to a second chip.

10. The apparatus of claim 9, wherein the interconnect layer includes a solder bump.

11. The apparatus of any one of claims 1-10, including a connector to couple the circuitry to the package substrate.

12. A method including:
preparing a first die including circuitry on a first surface;
disposing a capacitor adjacent to a second surface of the first die, the second surface opposite the first surface; and
mounting a second die on the second surface of the first die, the second die electrically coupled to the capacitor.

13. The method of claim 12, wherein the disposing of the capacitor adjacent to the second surface of the first die includes:
patterning an opening in the second surface; and
depositing a capacitor in the opening.

14. The method of any one of claim 12, wherein the disposing of the capacitor adjacent to the second surface of the first die includes:
depositing a redistribution layer on the first surface; and
depositing a capacitor layer on the redistribution layer, the capacitor layer including the capacitor.

15. The method of claim 14, wherein the redistribution layer is a first redistribution layer and including:
depositing a second redistribution layer on the capacitor layer; and
depositing an interconnect layer on the second redistribution layer.
